# DEMANDE DE BREVET EUROPEEN

(11) **EP 1 089 287 A1**
(43) Date de publication de la demande: **04.04.2001**
(21) Numéro de dépôt: 00402335.4
(22) Date de dépôt: 22.08.2000
(51) Int. Cl.: G11C 8/00, G11C 5/06

(54) **Procédé de sélection d'une ligne d'accès à une mémoire, décodeur de ligne d'accès et mémoire l'incorporant.**

(30) Priorité: 29.09.1999 FR 9912148
(71) Demandeur: STMicroelectronics SA, 94250 Gentilly (FR)
(72) Inventeur: Zink, Sébastien, 75116 Paris (FR); Bertrand, Bertrand, 75116 Paris (FR); Naura, David, 75116 Paris (FR)
(74) Mandataire: Ballot, Paul

(57) **Abrégé**

L'invention propose un procédé de sélection d'une ligne d'accès déterminée d'une mémoire en circuit intégré à accès série, notamment une mémoire en technologie EEPROM, une ligne d'accès déterminée pouvant être sélectionnée parmi un groupe déterminé de lignes d'accès (AL0-AL7) de même nature, par exemple un groupe de lignes de bits ou un groupe de lignes de mots, un code de ligne sur p bits étant respectivement associé à chaque ligne d'accès dudit groupe, qui consiste à pré-activer toutes les lignes d'accès du groupe puis à désactiver progressivement les autres lignes d'accès, en fonction des bits (Ai) du code de ligne de la ligne d'accès à sélectionner reçus en série par l'intermédiaire de l'entrée de données série de la mémoire, en sorte que, à la fin, seule la ligne d'accès à sélectionner reste activée.

## Description

La présente invention concerne un procédé de sélection d'une ligne d'accès à une mémoire en circuit intégré, du type à accès série, ainsi qu'un décodeur de ligne d'accès mettant en oeuvre le procédé et une mémoire incorporant un tel dispositif.

Elle se rapporte au domaine des mémoires en circuit intégré, notamment en technologie EEPROM (de l'anglais "Electrically Erasable and Programmable Read Only Memory" qui signifie mémoire à lecture seule programmable et effaçable électriquement"). Néanmoins, elle peut aussi s'appliquer à une mémoire dans une autre technologie, par exemple une mémoire en technologie Flash-EPROM, ou autre.

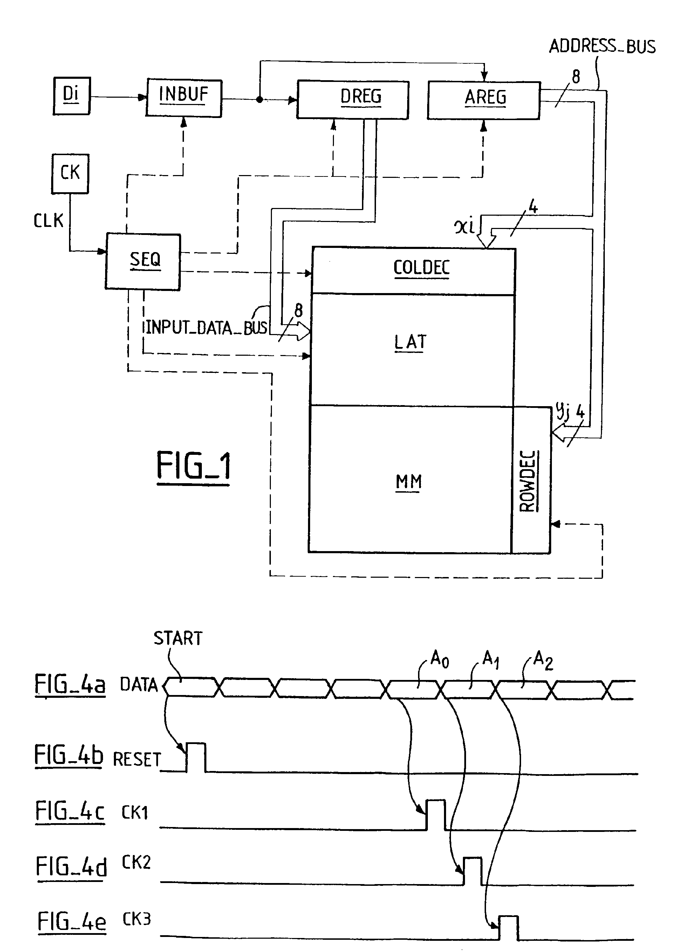

L'architecture d'une mémoire à accès série, telle qu'elle est connue dans l'état de la technique, est représentée schématiquement à la figure 1.

La mémoire comprend tout d'abord un plan mémoire MM proprement dit. Le plan mémoire est constitué d'une matrice de cellules mémoire réalisées selon la technologie considérée. Une cellule mémoire mémorise la valeur d'un bit de la mémoire. Les cellules d'une même colonne sont connectées à une même ligne de connexion, classiquement représentée verticalement et appelée ligne de bits. En outre, les cellules d'une même ligne sont connectées à une même ligne de connexion, classiquement représentée horizontalement et appelée ligne de mots. Dans la suite, les lignes de mots et les lignes de bits seront aussi désignées par l'expression générique "ligne d'accès".

En effet, pour accéder à une cellule (par exemple pour une opération de lecture ou d'écriture), il faut activer la ligne de bits et la ligne de mots auxquelles cette cellule est connectée. Par le terme activer, on entend le fait de porter la ligne d'accès considérée à un potentiel déterminé (qui est fonction de l'opération à effectuer). Le fait d'activer l'une déterminée des lignes d'accès d'un même groupe (de lignes de bits ou de lignes de mots), et celle-là uniquement, est appelée sélection de la ligne d'accès. Cette sélection d'une ligne d'accès est effectuée au moyen d'un circuit décodeur, appelé plus simplement décodeur de lignes d'accès. La mémoire comprend ainsi un décodeur de lignes de mots ROWDEC et un décodeur de lignes de bits COLDEC.

La mémoire comprend encore un ensemble LAT de registres de colonnes ("Column Register", en anglais) coopérant avec le décodeur de lignes de bits pour activer les lignes de bits.

Pour l'écriture ou la lecture d'un mot binaire dans la mémoire, une instruction est reçue sur une entrée de données série DI de la mémoire, selon un protocole de transmission série déterminé (par exemple le protocole I²C, le protocole SPI ou le protocole MICROWIRE). Les données binaires de l'instruction étant transmises sur cette entrée sous forme d'un signal électrique, elles sont tout d'abord, en général, remises en forme grâce à un circuit tampon d'entrée INBUF ("Input Buffer", en anglais). Un tel circuit n'est cependant pas obligatoire, et peut être omis dans certaines applications. En général, les informations suivantes sont contenues dans l'instruction : un code d'opération (exemple : écriture ou lecture), une adresse de la mémoire désignant un mot mémoire, et le cas échéant au moins un mot de données à écrire (pour une opération d'écriture). Un séquenceur SEQ génère des signaux de commande adaptés à la bonne gestion de la mémoire lors de l'exécution de l'instruction reçue. Le séquenceur SEQ reçoit un signal d'horloge CLK par l'intermédiaire d'une entrée d'horloge CK de la mémoire. Les signaux de commande qu'il génère sont schématiquement matérialisés par des flèches en traits discontinus.

Ainsi, les données correspondant à l'adresse du mot mémoire concerné par l'opération sont chargées dans un registre à décalage ou registre d'adresse AREG, sous la commande du séquenceur SEQ. De là, un bus d'adresse ADDRESS_BUS transmet une première partie xᵢ de l'adresse du mot mémoire, appelée adresse de colonne, jusqu'au décodeur de lignes de bits COLDEC, et une autre partie yⱼ de l'adresse du mot mémoire, appelée adresse de ligne, jusqu'au décodeur de lignes de mots ROWDEC. Dans l'exemple représenté à la figure 1, l'adresse complète d'un mot mémoire est codée sur huit bits, en sorte que le bus ADDRESS_BUS comporte huit lignes de transmission. L'adresse est ensuite divisée en deux parties xᵢ et yⱼ de quatre bits chacune, en sorte que le bus ADDRESS_BUS se divise en deux parties de quatre lignes de transmission chacune. Le registre d'adresse AREG est alors un registre huit bits, c'est à dire qu'il comprend huit bascules de mémorisation en série, pour la mémorisation respectivement de huit bits d'adresse reçus consécutivement. Il assure une fonction de conversion série/parallèle du flot de bits d'adresse reçus par la mémoire via l'entrée DI. En effet, une sortie de chacune des huit bascules du registre AREG est reliée respectivement à l'une des huit lignes de transmission du bus d'adresse ADDRESS_BUS.

De même, les données de l'instruction correspondant au mot de données à écrire (le cas échéant) sont chargées dans un registre à décalage d'entrée DREG, sous la commande du séquenceur SEQ. Le registre DREG est un registre huit bits, c'est à dire qu'il comprend huit bascules de mémorisation en série, pour la mémorisation respectivement de huit bits de données reçues consécutivement. Le registre à décalage DREG assure une fonction de conversion série/parallèle du flot de bits de données reçus par la mémoire via l'entrée de données série DI. En effet, une sortie de chacune des huit bascules du registre DREG est reliée respectivement à l'une des huit lignes de transmission d'un bus d'entrée de données INPUT_DATA_BUS. Le bus INPUT_DATA_BUS est par ailleurs relié à l'ensemble LAT de registres de colonnes pour y délivrer, sous forme parallèle, huit bits de données. Ces données binaires sont chargées dans des bascules de mémorisation et de commutation du registre de colonne associé au mot mémoire concerné, sous la commande du séquenceur SEQ.

Selon un inconvénient des mémoires à accès série d'architecture connue, le registre d'adresse AREG occupe beaucoup de place sur le substrat de silicium dopé sur lequel la mémoire est réalisée. Ceci est dû au nombre important de transistors qui le composent. On conçoit que cette surface occupée par le registre à décalage soit pénalisante en termes de coût de fabrication, surtout pour les mémoires de faible capacité (avec peu d'octets mémorisés).

L'invention vise à pallier cet inconvénient des mémoires de l'état de la technique.

A cet effet, l'invention propose un procédé de sélection d'une ligne d'accès déterminée d'une mémoire en circuit intégré à accès série, notamment une mémoire en technologie EEPROM, une ligne d'accès déterminée pouvant être sélectionnée parmi un groupe de lignes d'accès de même nature, par exemple un groupe de lignes de bits ou un groupe de lignes de mots, un code de ligne sur p bits étant respectivement associé à chaque ligne d'accès dudit groupe, procédé qui comporte les étapes suivantes :
a) activation de toutes les lignes d'accès du groupe ;
b) réception, par l'intermédiaire d'une entrée de données série de la mémoire, d'un bit de rang déterminé du code de la ligne d'accès à sélectionner ;
c) et, en fonction de la valeur du bit reçu à l'étape précédente, désactivation d'une partie des autres lignes d'accès ,
les étapes b) et c) étant répétées p fois successivement, respectivement pour chacun des bits du code de ligne reçu, par l'intermédiaire de l'entrée de données série de la mémoire, en sorte qu'à l'issue de ces p itérations des étapes b) et c), seule la ligne d'accès à sélectionner reste activée.

Pour sélectionner une ligne d'accès déterminée, le procédé selon l'invention consiste donc, dans un premier temps, à "pré-activer" toutes les lignes d'accès du groupe puis, dans un second temps à désactiver progressivement les autres lignes d'accès, en fonction des bits du code de ligne de la ligne d'accès à sélectionner qui sont reçus en série par l'intermédiaire de l'entrée de données série de la mémoire, en sorte que, à la fin, seule la ligne d'accès à sélectionner reste activée. Cette méthode rend inutile un registre à décalage tel que le registre d'adresse AREG de la figure 1. L'invention permet donc la réalisation de mémoires à accès série occupant moins de surface sur le substrat de silicium dopé.

La sélection d'une ligne d'accès de la mémoire étant, comme il a été dit plus haut, réalisée par un décodeur de ligne d'accès, l'invention propose également un tel décodeur pour la mise en oeuvre d'un procédé tel que défini ci-dessus.

En outre, l'invention propose encore une mémoire en circuit intégré, du type à accès série, notamment en technologie EEPROM, comportant une entrée de données série et un plan mémoire proprement dit qui comprend des cellules mémoire sous la forme d'une matrice et accessibles par un groupe de ligne de bits et un groupe de lignes de mots, caractérisée en ce qu'elle comprend un décodeur de lignes de bits et/ou un décodeur de lignes de mots du type mentionné ci-dessus.

D'autres caractéristiques et avantages de l'invention apparaîtront à la lecture de la description qui va suivre. Celle-ci est purement illustrative et doit être lue en regard des dessins annexés, sur lesquels on a représenté :
- à la figure 1, déjà analysée : le schéma d'une mémoire à accès série selon l'état de la technique ;
- à la figure 2 : le schéma d'une bascule d'un décodeur de ligne d'accès selon l'invention ;
- à la figure 3 : le schéma d'un décodeur de ligne d'accès selon l'invention ;
- aux figures 4a à 4e : des chronogrammes de signaux intervenant dans le fonctionnement du décodeur de la figure 3 ;
- à la figure 5 : le schéma d'une mémoire à accès série selon l'invention;
- à la figure 6 : le schéma de moyens complémentaires du décodeur selon l'invention, permettant la sélection séquentielle des lignes d'accès de la mémoire ;
- aux figures 7a à 7c: des chronogrammes de signaux intervenant dans le fonctionnement des moyens de la figure 6.

A la figure 2, on a représenté le schéma d'une bascule 10 d'un décodeur de ligne d'accès selon l'invention.

Une telle bascule comprend des moyens de commutation comprenant un inverseur I1 connecté par son entrée à un noeud d'entrée H et par sa sortie à une sortie S de la bascule. La sortie S est destinée à être reliée à une unique ligne d'accès déterminée du groupe de lignes d'accès concerné par le décodeur. Dans un état activé de la bascule, la ligne d'accès est activée. Dans un état désactivé de la bascule, la ligne d'accès est désactivée. On désigne par état activé de la bascule l'état dans lequel un potentiel non nul est imposé sur la sortie S et donc sur la ligne d'accès à laquelle cette sortie est reliée. A l'inverse, on désigne par état désactivé de la bascule l'état dans lequel un potentiel nul est imposé sur la ligne d'accès. Dit autrement, l'inverseur a pour fonction d'imposer ledit potentiel non nul ou ledit potentiel nul sur la sortie S de la bascule lorsque le potentiel sur ledit noeud d'entrée H de la bascule est respectivement nul ou non nul.

L'inverseur I1 est par exemple un inverseur en technologie CMOS, c'est à dire comprenant un transistor MOS de type P et un transistor MOS de type N, dont les grilles de commande sont communes, disposés en série entre un potentiel non nul V1 et un potentiel nul constitué par la masse du circuit intégré. Dans ces conditions, le potentiel non nul dont il est question au paragraphe ci-dessus est ledit potentiel V1. En outre, la mémoire comprend des moyens (non représentés) pour faire en sorte que le potentiel V1 soit égal à une haute tension de programmation VPP (référencée par rapport à la masse), de l'ordre de 18 volts, ou à la basse tension d'alimentation VCC du circuit intégré (référencée par rapport à la masse), de l'ordre de 5 volts, ou encore à un autre potentiel, en fonction de l'opération en cours (lecture, programmation, ou effacement).

La bascule comprend des moyens de stabilisation, pour maintenir la bascule dans l'état désactivé malgré l'existence de courants de fuite ou autres phénomènes de même nature. Ces moyens comprennent un transistor MOS de type P, référencé P2, qui est relié par son drain au noeud d'entrée H, par sa source à un potentiel positif V3, et par sa grille de commande à la sortie S. Ainsi connecté, le transistor P2 assure un bouclage pour compenser les courants de fuite éventuels, afin de maintenir la bascule dans l'état désactivé, dès lors que d'autres moyens ne la mettent pas dans l'état activé. Bien entendu, ces moyens de stabilisation n'agissent qu'à défaut d'action de la part d'autres moyens ayant eux pour effet de mettre la bascule dans l'état activé. Dit autrement, le transistor P2 ne remplit sa fonction de maintien de la bascule dans l'état désactivé qu'à défaut d'action de ces autres moyens. A cet effet, le transistor P2 est très résistif (il présente une résistivité importante).

En effet, la bascule comprend aussi des moyens d'activation, pour mettre la bascule dans l'état activé, qui s'opposent aux moyens de stabilisation précités. Ces moyens d'activation comprennent un moyen formant interrupteur commandé pour imposer un potentiel nul sur le noeud d'entrée H de la bascule. Cet interrupteur commandé est par exemple un transistor MOS de type N référencé N2, relié par son drain au noeud d'entrée H, par sa source à la masse, et par sa grille de commande à une entrée E de la mémoire. En fonctionnement, cette entrée E peut recevoir un signal d'initialisation RESET actif à 1 pour imposer le potentiel nul sur le noeud H. Un tel transistor a bien pour effet d'activer la bascule en fonction du signal RESET. Comme on le verra plus loin, le décodeur de lignes d'accès comporte des moyens pour mettre toutes les bascules dans l'état activé de préférence simultanément. Ces moyens permettent par exemple d'appliquer le signal RESET précité sur les entrées E de toutes les bascules de décodeur, si bien que toutes les bascules sont activées simultanément.

La bascule comprend aussi des moyens de désactivation, pour mettre la bascule dans l'état désactivé. Ces moyens de désactivation comprennent des moyens de décodage qui permettent d'imposer un potentiel nul sur le noeud d'entrée H de la bascule en fonction d'un code de ligne qui est propre à ladite ligne d'accès et en fonction de signaux de sélection reçus par les moyens de décodage, coopérant avec des moyens supplétifs pour imposer un potentiel non nul sur ledit noeud d'entrée H de la bascule, qui agissent à défaut d'action des moyens de décodage. Dit autrement, la désactivation de la bascule est obtenue par l'effet de ces derniers moyens, à moins qu'ils ne soient privés d'effet par les moyens de décodage.

Les moyens de décodage comprennent, en série entre le noeud d'entrée H et la masse, p transistors MOS de type N, où p est le nombre de bits codant le code de ligne d'une ligne d'accès. Dans un exemple où p est égal à trois, ces transistors sont référencés M0 à M2. Les grilles de commande des transistors M0 à M2 sont reliées à des entrées de sélection de la bascule référencées respectivement B0 à B2, pour recevoir chacun respectivement l'un parmi trois signaux de sélection Bit0, Bit1, Bit2, ou, respectivement, Bit0 barre, Bit1 barre, Bit2 barre. On reviendra plus loin sur ces signaux de sélection. Toutefois, on indique dès à présent que c'est la combinaison des signaux de sélection reçus sur les entrées de sélection B0 à B2 de la bascule qui détermine la conditions d'activation de la bascule, c'est à dire qui identifie la bascule par le code de ligne de la ligne d'accès à laquelle elle est couplée. En série avec les transistors M0 à M2 entre le noeud d'entrée H et la masse, les moyens de décodage comprennent aussi un autre transistor MOS de type N, référencé N1, dont la grille de commande est reliée à la sortie S de la bascule. La fonction de ce transistor est de faire en sorte que les moyens de décodage n'aient d'effet que lorsque la bascule est activée.

Les moyens pour imposer un potentiel non nul sur le noeud d'entrée H de la bascule comprennent deux transistors MOS de type P, référencés P1 et P3, en série entre ledit noeud d'entrée H et un potentiel positif V2. La grille de commande du transistor P1 est reliée à une entrée G de la bascule pour recevoir un signal DEC qui, par défaut est à 0 en sorte qu'il rend conducteur le transistor P1. La grille de commande du transistor P3 est reliée au drain du transistor NI en sorte qu'elle est au potentiel nul de la masse lorsque la bascule est activée, et en sorte qu'elle rend le transistor P3 conducteur dans ce cas. Le potentiel V2 est par exemple égal à VCC. On notera d'une part que, lorsque la bascule est activée, et le signal DEC étant à 0, les transistors P1 et P3 tendent à imposer un potentiel non nul égal à V2 sur le noeud d'entrée H. On notera d'autre part que, lorsque la bascule est pareillement activée (en sorte que le transistor NI est conducteur) mais lorsque, de plus, les transistors M0 à M2 des moyens de décodage reçoivent, sur leurs grilles de commande respectives, des signaux de sélection tels qu'ils les rendent conducteurs, les moyens de décodage tendent à imposer le potentiel nul de la masse sur le même noeud d'entrée H. Pour arbitrer ce conflit, on prévoit que les transistors P1 et P3 sont très résistifs afin que ce soient alors les moyens de décodage qui l'emportent en sorte que le potentiel sur le noeud d'entrée H soit le potentiel nul de la masse. Un faible courant circule entre VCC et la masse dans ce cas. De cette manière, on peut considérer que les transistors P1 et P3 n'ont pour effet d'imposer le potentiel non nul V2 sur le noeud d'entrée H que lorsque les moyens de décodage n'ont pas d'effet, c'est à dire lorsque l'un des transistors M0, M1, M2 ou N1 est non conducteur.

Sur le schéma de la figure 2, une connexion relie le noeud d'entrée H à une sortie F de la bascule sur laquelle on reviendra plus loin. Toutefois, on notera d'ores et déjà que, en raison de l'inverseur I1, le potentiel sur la sortie F est l'inverse du potentiel sur la sortie S.

Sur la figure 3, on a représenté un décodeur de lignes d'accès selon l'invention, convenant pour la sélection d'une ligne d'accès parmi un groupe de huit lignes d'accès de même nature. Dans cet exemple, un code de ligne sur trois bits est associé à chaque ligne d'accès (dit autrement, p est égale à trois). Il faut donc traiter trois bits d'adresse reçus via l'entrée de données série de la mémoire pour sélectionner une des lignes d'accès. Ces bits d'adresse ne sont rien d'autre que les bits du code de ligne de la ligne à sélectionner.

Un tel décodeur comprend à cet effet huit bascules telles que celle présentée ci-dessus en regard la figure 2, qui sont référencées 100 à 107. Ces bascules sont couplées chacune à une ligne d'accès d'un groupe de lignes d'accès de même nature. Plus particulièrement, les sorties S de ces huit bascules sont reliées chacune à une parmi huit lignes d'accès, respectivement AL0 à AL7. Dans le cas d'un décodeur de lignes de bits, les lignes AL0 à AL7 sont des lignes de bits. Dans le cas d'un décodeur de lignes de mots, les lignes AL0 à AL7 sont des lignes de mots.

Le décodeur comporte également des moyens pour mettre toutes les bascules dans l'état activé. Ces moyens comprennent de préférence des connexions pour appliquer le signal d'initialisation RESET précité sur les entrées E respectives de toutes les bascules. De cette manière, les bascules 100 à 107 peuvent être activées simultanément par le passage à 1 du signal RESET.

Le décodeur comporte également des connexions pour appliquer le signal DEC précité sur les entrées G respectives de toutes les bascules.

Le décodeur comporte surtout des moyens pour générer les signaux de sélection précités, qui sont référencés Bit0, Bit1, Bit2, Bit0 barre, Bit1 barre, et Bit2 barre à la figure 3. Ces moyens permettent de générer lesdits signaux de sélection en fonction des bits du code de ligne de la ligne d'accès à sélectionner reçus en série par l'intermédiaire de l'entrée de données série DI de la mémoire.

Ces moyens comprennent six portes logiques de type NON ET, référencées NE1 à NE6, dont les sorties sont reliées à des lignes de connexion respectivement Ll à L6, et génèrent lesdits signaux de sélection respectivement Bit0, Bit1, Bit2, Bit0 barre, Bit1 barre, et Bit2 barre.

Une première entrée des portes NE1 à NE3 reçoit un signal Ai qui n'est autre que le bit d'adresse courant reçu par la mémoire via son entrée de données série, et, le cas échéant, via également le circuit tampon d'entrée INBUF. Les secondes entrées respectives desdites portes NE1 à NE3 reçoivent un signal de synchronisation respectivement CK1 à CK3. Une première entrée des portes NE4 à NE6 reçoit un signal Ai barre qui est l'inverse logique du signal Ai, c'est à dire l'inverse logique du bit d'adresse courant reçu par la mémoire. Le bit Ai barre est obtenu par inversion logique du bit Ai à l'aide d'un inverseur I2. Les secondes entrées respectives desdites portes NE4 à NE6 reçoivent ledit signal de synchronisation respectivement CK1 à CK3. Dit de manière plus générale, et pour des codes de ligne codés sur p bits, les moyens pour générer les signaux de sélection Bit0, Bit1, Bit2, Bit0 barre, Bit1 barre, Bit2 barre comprennent :
- p portes logiques de type NON ET qui, ensemble, reçoivent, sur une première entrée, successivement les p bits du code de ligne reçu, et qui, chacune, reçoivent, sur une seconde entrée, l'un parmi p signaux de synchronisation présentant une impulsion en phase, respectivement, avec le p-ième bit du code de ligne reçu ;
- p autres portes logiques de type NON ET qui, ensemble, reçoivent sur une première entrée, successivement l'inverse logique des p bits du code de ligne reçu, et qui, chacune, reçoivent sur une seconde entrée, l'un parmi p signaux de synchronisation présentant une impulsion en phase, respectivement, avec le p-ième bit du code de ligne reçu.

L'allure des signaux de synchronisation CK1 à CK3 est visible sur les chronogrammes des figures 4c à 4e respectivement. Ces signaux présentent chacun une impulsion en phase avec un bit d'adresse respectivement 0 à A2 reçu via l'entrée de donnée série DI de la mémoire. Le flot de bits DATA reçu sur cette entrée DI est représenté symboliquement sur le chronogramme de la figure 4a. Il s'agit des bits codant une instruction. On notera que des signaux de synchronisation tels que les signaux CK1 à CK3 existent déjà dans les mémoires de l'état de la technique. Ils sont générés par le séquenceur SEQ (figure 1) pour, précisément, synchroniser le fonctionnement de la mémoire, et notamment, mais pas uniquement, de son registre d'adresse AREG. Avantageusement, l'invention ne requiert donc pas de moyens pour la génération de ces signaux de synchronisation autres que ceux déjà présents dans une mémoire de type connu.

Le flot de bits DATA est reçu au rythme du signal d'horloge CLK de la mémoire (non représenté), c'est à dire qu'il correspond à l'échantillonnage du signal électrique présent sur l'entrée de données série DI de la mémoire au rythme de ce signal. Il débute par un bit de démarrage, référencé START sur le chronogramme de la figure 4a. Ce bit START implique le passage à 1 du signal RESET visible sur le chronogramme de la figure 4b, ainsi que le montre schématiquement une flèche d'implication logique. Dans un exemple, le signal RESET reste à 1 au plus pendant une période du signal d'horloge. Les trois bits du flot DATA qui, dans un exemple, sont reçus entre le bit START et le premier bit d'adresse A0, correspondent par exemple au code de l'opération à effectuer dans la mémoire, à savoir : lecture, écriture, ou autre. Les bits suivants A0 à A2 sont les bits du code de la ligne d'accès à sélectionner et sont par exemple compris dans l'adresse d'un mot mémoire du plan mémoire sur lequel doit porter l'opération à effectuer. Dans le cas d'une opération d'écriture, le flot de bits DATA comporte encore des bits codant une ou plusieurs données à écrire. La structure du flot de bits DATA dépend du protocole de transmission série reconnu par la mémoire.

La réception du bit A0, puis A1 et A2, implique l'impulsion du signal de synchronisation respectivement CK1, CK2 et CK3, visibles aux figures 4c à 4e respectivement. Lesdites impulsions correspondent à un passage à 1 du signal de synchronisation concerné pendant au plus une période du signal d'horloge.

De retour au schéma de la figure 3, on notera ce qui suit concernant la connexion des moyens de génération des signaux de sélection aux entrées de sélection B0 à B2 des bascules :
- l'entrée B0 des bascules 100 à 103 est reliée à la ligne L4 alors que celle des bascules 104 à 107 est reliée à la ligne L1 ;
- l'entrée B1 des bascules 100, 102, 104, 105 est reliée à la ligne L5 alors que celle des bascules 101, 103, 106, et 107 est reliée à la ligne L2 ;
- l'entrée B2 des bascules 100, 101, 104 et 106 est reliée à la ligne L6, alors que celle des bascules 102, 103, 105 et 107 est reliée à la ligne L3.

De cette manière, on peut vérifier que les moyens de décodage respectifs des bascules 100 à 107 coopèrent avec les moyens de génération des signaux de sélection du décodeur d'une manière univoque. Les connexions ci-dessus permettent donc d'individualiser les bascules, et donc les lignes d'accès auxquelles elles sont couplées, par un code sur trois bits qui n'est autre que le code dit code de ligne.

Le fonctionnement du décodeur mettant en oeuvre le procédé de l'invention va maintenant être décrit, en se référant, en tant que de besoin, aux schémas des figures 2 et 3 et aux chronogrammes des figures 4a à 4e.

La sélection d'une ligne d'accès déterminée parmi le groupe des lignes d'accès de même nature, un code de ligne sur p bits étant respectivement associé à chaque ligne d'accès dudit groupe, comporte les étapes suivantes :
a) activation de toutes les lignes d'accès du groupe ;
b) réception, par l'intermédiaire de l'entrée de données série DI de la mémoire, d'un bit Ai de rang déterminé du code de la ligne d'accès à sélectionner ;
c) et, en fonction de la valeur du bit Ai reçu à l'étape précédente, désactivation d'une partie des autres lignes d'accès,
les étapes b) et c) étant répétées p fois successivement, respectivement pour chacun des bits du code de ligne de la ligne d'accès à sélectionner (qui sont reçus en série par l'intermédiaire de l'entrée de données série DI de la mémoire), en sorte que à l'issue de ces p itérations des étapes b) et c), seule la ligne d'accès à sélectionner reste activée.

L'obtention de ce résultat technique va maintenant être expliqué plus en détails, en considérant l'exemple du décodeur de la figure 3, dans le cas particulier où p est égale à trois.

Concernant l'étape a) : cette étape est réalisée par le passage à 1 du signal RESET tel que représenté sur le chronogramme de la figure 4b. Le transistor N2 de chaque bascule respectivement 100 à 107 est rendu conducteur par ce signal RESET en sorte que le noeud d'entrée H de chacune des bascules est porté au potentiel nul de la masse. Cela signifie que la sortie S de chacune des bascules est porté au potentiel non nul V1, c'est à dire que la ligne d'accès respectivement AL0 à AL7 est activée. Avantageusement, comme il a déjà été dit plus haut, toutes les lignes d'accès 100 à 107 sont activées simultanément à l'étape a). Ceci est plus simple puisque un seul et même signal RESET permet d'obtenir ce résultat.

Concernant l'étape b) : le bit Ai dont il est question ci-dessus est l'un des bits d'adresse A0 à A2 visibles sur le chronogramme de la figure 4a. On rappelle qu'il s'agit des bits du code de la ligne d'accès à sélectionner. Par convention, on considère que le bit A0 est reçu à la première itération de l'étape b), le bit A1 à la deuxième itération, et le bit A2 à la troisième itération.

Concernant l'étape c) : on notera que, avant le réception du premier des bits A0 à A2, toutes les lignes L1 à L6 sont à 1 puisque les signaux de synchronisation CK1, CK2 et CK3 sont à 0. Donc les transistors M0 à M2 de chacune des bascules respectivement 100 à 107 sont conducteurs. Or, le transistor N2 de chacune des bascules respectivement 100 à 107 est également conducteur puisque, après l'étape a), toutes ces bascules sont activées. Donc les moyens de décodage de chacune des bascules respectivement 100 à 107 ont pour effet d'imposer le potentiel nul de la masse sur le noeud d'entrée H de chacune des bascules respectivement 100 à 107, les moyens pour imposer le potentiel non nul V2 sur ce noeuds étant privés d'effet en raison de la forte résistivité électrique des transistors P1 et P3. Dit autrement, les moyens de décodage de chacune des bascules respectivement 100 à 107 prennent le dessus sur les moyens P1,P3 de chacune de ces bascules respectivement. On notera que le fait que le signal RESET soit repassé à 0 importe peu.

Soit j un indice qui identifie la j-ième itération de l'étape b) et de l'étape c). Le bit reçu en série par la mémoire à cette j-ième itération de l'étape b) est noté Aⱼ. Le signal de synchronisation CKⱼ est à l'état 1 puisqu'il présente alors une impulsion. La sortie de l'une des portes NEⱼ ou NEⱼ₊₃ passe à 0 selon la valeur du bit Aⱼ : si Aⱼ vaut 1 alors c'est la porte NEⱼ qui passe à 0 ; si Aⱼ vaut 0 alors c'est la porte NEⱼ₊₃ qui passe à 0. En conséquence, la ligne Lⱼ ou, respectivement, la ligne Lⱼ₊₃, passe à 0, si bien que le transistor Mⱼ d'une partie des bascules 100 à 107 devient non conducteur. Les moyens de décodage de ces bascules sont donc privés d'effet. Par conséquent, les moyens P1,P3 pour imposer un potentiel non nul sur le noeud d'entrée H qui leur sont associés agissent. Le noeud d'entrée H de ces bascules est donc porté au potentiel non nul V2, ce qui revient bien à dire que ces bascules sont désactivées.

On notera que la (ou les) ligne(s) d'accès qui est (sont) désactivée(s) à l'étape c) est (sont) la (les) ligne(s) d'accès dont le code de ligne présente un bit de rang j de valeur différente de celle du bit Aⱼ reçu à l'itération correspondante de l'étape b).

On notera également que dans le cas où le groupe de lignes d'accès comprenant 2P lignes d'accès, la moitié des lignes encore activée est désactivée à chaque itération de l'étape c).

Comme on l'a déjà exposé ci-dessus en regard de la description du chronogramme de la figure 4a, les bits du code de la ligne d'accès à sélectionner reçus par la mémoire lors des itérations successives de l'étape b) sont compris dans les bits d'adresse d'un mot mémoire de la mémoire sur lequel doit porter une opération définie par une instruction reçue selon un protocole série déterminé.

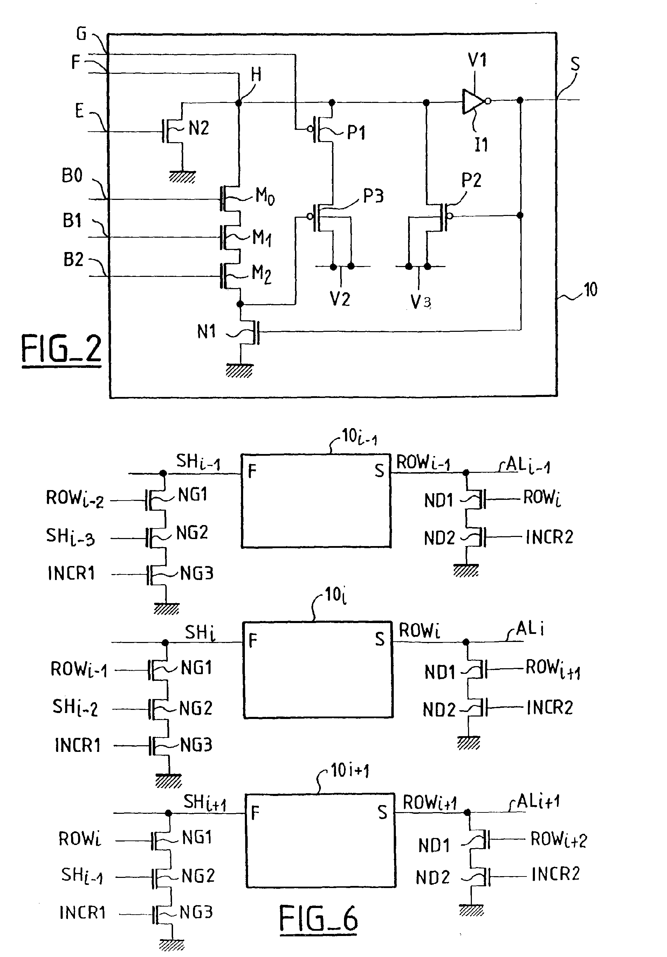

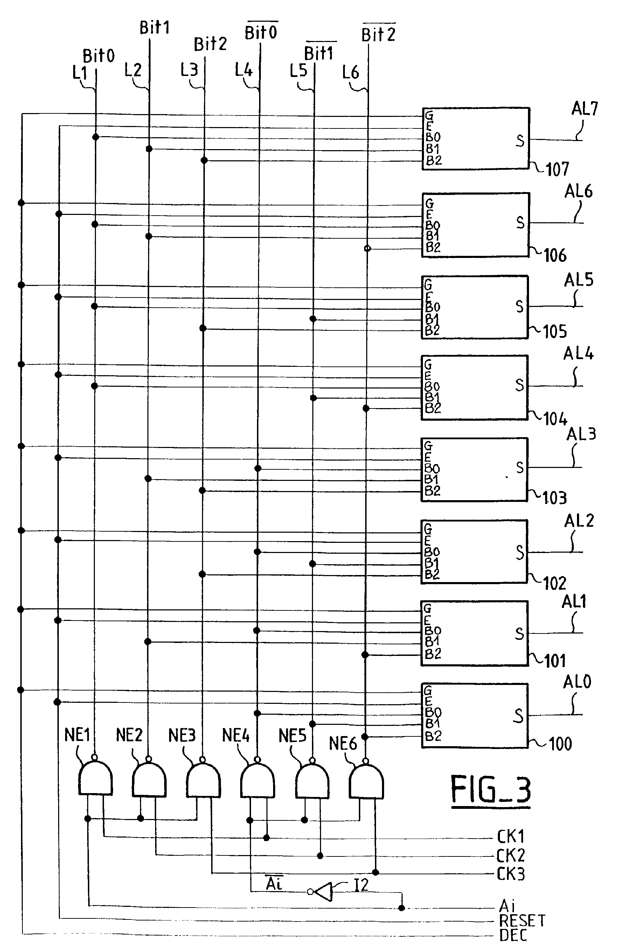

A la figure 5, on a représenté le schéma d'une mémoire selon l'invention. Sur cette figure, les mêmes éléments qu'à la figure 1 portent les même références. On se contentera ici de décrire les différences.

Les bits d'adresse reçus en série par l'intermédiaire de l'entrée de données DI (via le circuit tampon d'entrée INBUF le cas échéant) ne sont plus transmis dans un registre à décalage. Au contraire, ils sont transmis directement pour partie au décodeur de lignes ROWDEC et pour partie au décodeur de colonnes COLDEC. C'est pourquoi, la mémoire selon l'invention ne comprend pas de registre à décalage tel que le registre AREG de la figure 1, ni de bus d'adresse tel que le bus ADDRESS_BUS de la figure 1. A la place, elle comprend des moyens, comprenant une unique ligne d'adresse ADDRESS_LINE, pour relier directement l'entrée de données DI au décodeur de lignes de mots ROWDEC et/ou au décodeur de lignes de bits COLDEC, le cas échéant à travers le circuit tampon d'entrée INBUF. De ces différences, il résulte une réduction corrélative notable de la surface occupée par la mémoire sur le substrat de silicium dopé.

On va maintenant décrire un mode de réalisation particulier de l'invention, qui permet un adressage séquentiel de la mémoire. Par adressage séquentiel, on entend le fait de sélectionner un mot mémoire du plan mémoire non pas directement, en fournissant son adresse, mais en sélectionnant préalablement tous les mots qui le précèdent. Ceci suppose bien entendu une relation d'ordre entre les mots mémoires. Par extension il est alors nécessaire de procéder à une sélection séquentielle des lignes d'accès de la mémoire, ce qui suppose pareillement une relation d'ordre entre les lignes d'accès.

Dit autrement, l'invention prévoit aussi que, l'ensemble des lignes d'accès étant un ensemble ordonné, le procédé de sélection comprend de plus une étape d'activation de la ligne d'accès qui, dans l'ordre des lignes d'accès, suit une ligne d'accès déterminée qui est sélectionnée, puis une étape de désactivation de ladite ligne d'accès déterminée, en sorte que c'est alors ladite ligne d'accès suivante qui est sélectionnée.

Dans un exemple simple, l'ensemble des lignes d'accès est ordonné par l'ordre croissant ou décroissant des valeurs binaires des codes de ligne qui leur sont respectivement associés.

Un décodeur de ligne d'accès conforme à ce mode de réalisation particulier, représenté partiellement à la figure 6, comprend des moyens pour activer la ligne d'accès qui, dans l'ordre des lignes d'accès, suit une ligne d'accès déterminée qui est sélectionnée, et des moyens pour désactiver ladite ligne d'accès déterminée, en sorte que c'est alors la ligne d'accès suivante qui est sélectionnée.

A la figure 6, on a représenté de façon simplifiée trois bascules 10ᵢ₋₁, 10ᵢ et 10ᵢ₊₁ couplées respectivement à trois lignes d'accès ALᵢ₋₁, ALᵢ et ALᵢ₊₁ qui se suivent dans l'ordre des lignes d'accès mentionné plus haut. Par souci de simplification, seules les sorties F et S des bascules sont représentées. On note ROWᵢ le signal délivré par la sortie S de la bascule 10ᵢ et SHᵢ le signal délivré par la sortie F de cette bascule. Le signal ROWᵢ est à 1 lorsque la ligne d'accès ALᵢ est activée et il est à 0 lorsque cette ligne d'accès est désactivée. On notera que le signal SHᵢ est tout simplement l'inverse logique du signal ROWᵢ.

Les moyens précités du décodeur comprennent, pour chaque bascule, d'une part trois transistors MOS de type N référencés respectivement NG1, NG2 et NG3, qui sont connectés en série entre la sortie F et la masse, et d'autre part deux transistors MOS de type N référencés respectivement ND1 et ND2, qui sont connectés en série entre la sortie S et la masse.

Pour l'une quelconque des bascules, par exemple la bascule 10ᵢ d'indice i, le transistor NG1 reçoit sur sa grille de commande le signal ROWᵢ₋₁, le transistor NG2 reçoit sur sa grille de commande le signal SHᵢ₋₂, et le transistor NG3 reçoit sur sa grille de commande un premier signal de commande INCR1, alors que le transistor ND1 reçoit sur sa grille de commande le signal ROWᵢ₊₁, et le transistor ND2 reçoit sur sa grille de commande un second signal de commande INCR2. Bien entendu, pour une autre bascule 10ᵢ₊ₖ, suivante ou précédente, d'indice quelconque i+k (avec k positif ou négatif), les signaux ROWᵢ₋₁, SHᵢ₋₂, et ROWᵢ₊₁ ci-dessus sont remplacés par les signaux correspondants respectivement ROWᵢ₊ₖ₋₁, SHᵢ₊ₖ₋₂, et ROWᵢ₊ₖ₊₁.

Dit autrement, les trois transistors NG1, NG2 et NG3 réalisent la combinaison des signaux ROWᵢ₋₁, SHᵢ₋₂, et INCR1 dans un opération logique de type ET, pour imposer le potentiel nul de la masse sur le noeud d'entrée H de la bascule, c'est à dire pour activer la bascule, lorsque ces trois signaux sont à 1 simultanément. Dit autrement encore, ces trois transistors sont des moyens, commandés par le premier signal de commande INCR1, pour activer la ligne d'accès associée à la bascule lorsque la ligne d'accès précédente est activée et celle qui précède cette dernière n'est pas activée. A l'inverse, les deux transistors ND1 et ND2 réalisent la combinaison logique des signaux ROWᵢ₊₁ et INCR2 dans une opération de type ET, pour imposer le potentiel nul de la masse sur la sortie S de la bascule, c'est à dire pour désactiver la bascule, lorsque ces deux signaux sont simultanément à 1. Dit autrement encore, ces deux transistors sont des moyens, commandés par le second signal de commande INCR2, pour désactiver une ligne d'accès associée à la bascule lorsque la ligne d'accès suivante est activée.

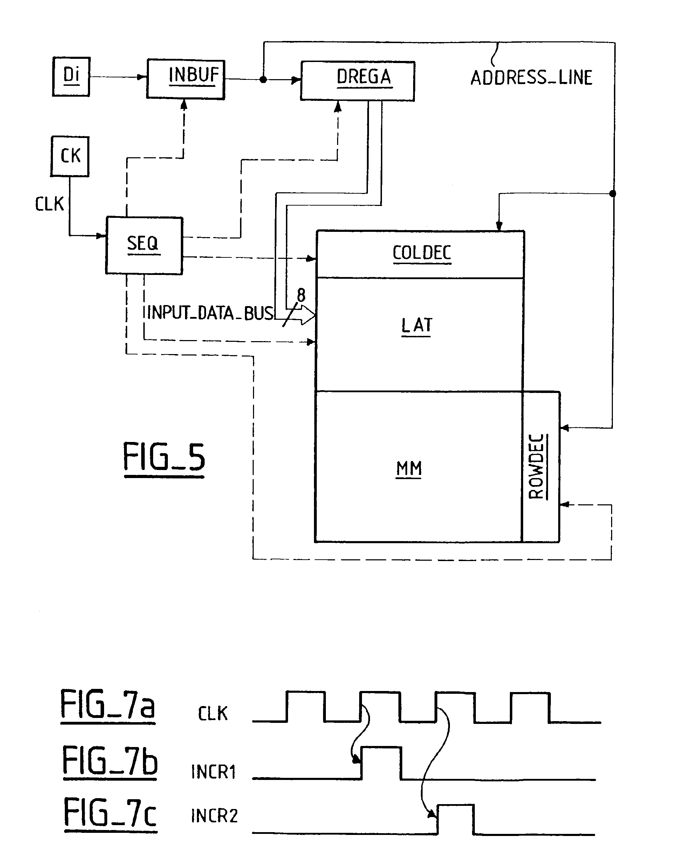

Comme on l'aura compris, le séquencement des signaux INCR1 et INCR2 permet de passer de la situation de départ envisagée à la situation d'arrivée souhaitée. Aux figures 7b et 7c, on a représenté les signaux de commande respectivement INCR1 et INCR2, en regard du signal d'horloge CLK de la mémoire, qui est représenté à la figure 7a.

Pour expliquer la sélection séquentielle des lignes d'accès de la mémoire, il faut considérer comme situation de départ celle dans laquelle seule la ligne d'accès ALᵢ est activée (c'est à dire dans laquelle la ligne ALᵢ est sélectionnée). La sélection séquentielle consiste à sélectionner la ligne suivante, à savoir la ligne ALᵢ₊₁. La situation d'arrivée est donc celle dans laquelle seule la ligne d'accès ALᵢ₊₁ est activée. On va maintenant décrire comment, grâce aux moyens précités, on peut parvenir à ce résultat. Comme on l'aura compris, c'est le séquencement des signaux INCR1 et INCR2 qui permet de passer de la situation de départ envisagée à la situation d'arrivée souhaitée.

Dans la situation de départ, les signaux ROWⱼ sont à 0 pour tout j différent de i. De plus, et corrélativement, les signaux SHⱼ sont à 1 pour tout j différent de i. Par contre le signal ROWᵢ est à 1 et, corrélativement, le signal SHᵢ est à 0. Pour passer dans la situation d'arrivée, on procède en deux temps :
- dans un premier temps, on génère une impulsion du signal INCR1, par exemple sur une impulsion du signal d'horloge CLK (voir figures 7a et 7b) ; la longueur de cette impulsion est au plus égale à une période du signal d'horloge ; comme les signaux ROWᵢ et SHᵢ₋₁ sont à 1, la bascule 10ᵢ₊₁ est activée c'est à dire que la ligne d'accès ALᵢ₊₁ est activée ; on notera que, en plus de la ligne ALᵢ déjà activée, seule cette ligne d'accès ALᵢ₊₁ est alors activée ; il reste donc à désactiver la ligne ALᵢ pour obtenir le résultat recherché ; c'est ce qu'on fait dans un second temps ;
- en effet, dans un second temps, on génère une impulsion du signal INCR1, par exemple pendant l'impulsion suivante du signal d'horloge CLK (voir figures 7a et 7c) ; la longueur de cette impulsion est au plus égale à une période du signal d'horloge ; comme le signal ROWᵢ₊₁ est à 1, la bascule 10ᵢ est désactivée c'est à dire que la ligne d'accès ALᵢ est désactivée ; on notera que la bascule 10ᵢ₊₁ n'est pas désactivée car le signal ROWᵢ₊₂ est à 0 ; on notera également que les signaux ROWᵢ et INCR2 étant à 1, ils tendent à désactiver la bascule 10ᵢ₋₁ mais on observe que cela est sans incidence car cette bascule était déjà dans l'état désactivé.

## Revendications

1. Procédé de sélection d'une ligne d'accès déterminée d'une mémoire en circuit intégré à accès série, notamment une mémoire en technologie EEPROM, une ligne d'accès déterminée pouvant être sélectionnée parmi un groupe de lignes d'accès de même nature, par exemple un groupe de lignes de bits ou un groupe de lignes de mots, un code de ligne sur p bits étant respectivement associé à chaque ligne d'accès dudit groupe, caractérisé en ce qu'il comporte les étapes suivantes :
a) activation de toutes les lignes d'accès du groupe (AL0-AL7);
b) réception, par l'intermédiaire d'une entrée de données série (DI) de la mémoire, d'un bit (Ai) de rang déterminé du code de la ligne d'accès à sélectionner ;
c) et, en fonction de la valeur du bit (Ai) reçu à l'étape précédente, désactivation d'une partie des autres lignes d'accès ,
les étapes b) et c) étant répétées p fois successivement, respectivement pour chacun des bits du code de ligne reçu par l'intermédiaire de l'entrée de données série (DI) de la mémoire, en sorte qu'à l'issue de ces p itérations des étapes b) et c), seule la ligne d'accès à sélectionner reste activée.

2. Procédé selon la revendication 1, caractérisé en ce que, la (ou les) ligne(s) d'accès qui est (sont) désactivée(s) à l'étape c) est (sont) la (les) ligne(s) d'accès dont le code de ligne présente un bit de rang i de valeur différente de celle du bit reçu (Ai) à l'itération correspondante de l'étape b).

3. Procédé selon l'une des revendications 1 ou 2, caractérisé en ce que, le groupe de ligne d'accès comprenant 2^{p} lignes d'accès, la moitié des lignes encore activée est désactivée à chaque itération de l'étape c).

4. Procédé selon l'une des revendications 1 à 3, caractérisé en ce que, à l'étape a), toutes les lignes d'accès sont activées simultanément.

5. Procédé selon l'une des revendications 1 à 4, caractérisé en ce que les bits du code de la ligne d'accès à sélectionner reçus par la mémoire lors des itérations successives de l'étape b) sont compris dans les bits d'adresse d'un mot mémoire de la mémoire sur lequel doit porter une opération définie par une instruction reçue selon un protocole série déterminé.

6. Procédé selon l'une des revendications 1 à 5, caractérisé en ce que, l'ensemble des lignes d'accès étant un ensemble ordonné, il comprend de plus une étape d'activation de la ligne d'accès qui, dans l'ordre des lignes d'accès, suit une ligne d'accès déterminée qui est sélectionnée, puis une étape de désactivation de ladite ligne d'accès déterminée, en sorte que c'est alors ladite ligne d'accès suivante qui est sélectionnée.

7. Procédé selon la revendication 6, caractérisé en ce que l'ensemble des lignes d'accès est ordonné par l'ordre croissant ou décroissant des valeurs binaires des codes de ligne qui leur sont respectivement associés.

8. Décodeur de lignes d'accès pour la mise en oeuvre d'un procédé selon l'une quelconque des revendications 1 à 7, caractérisé en ce qu'il comporte :
- des bascules, chacune couplée à une ligne d'accès d'un groupe de lignes d'accès de même nature, comprenant chacune des moyens de commutation pour imposer un potentiel non nul sur la ligne d'accès lorsque la bascule est dans un état activé et un potentiel nul lorsqu'elle est dans un état désactivé, des moyens d'activation pour mettre la bascule dans l'état activé, ainsi que des moyens de désactivation pour mettre la bascule dans l'état désactivé en fonction d'un code de ligne qui est propre à ladite ligne d'accès et en fonction de signaux de sélection (Bit0, Bit1, Bit₂, Bit0 barre, Bit1 barre, Bit2 barre) reçus par les moyens de désactivation;
- des moyens pour mettre toutes les bascules dans l'état activé;
- des moyens pour générer lesdits signaux de sélection (Bit0, Bit1, Bit2, Bit0 barre, Bit1 barre, Bit2 barre) en fonction des bits du code de ligne de la ligne d'accès à sélectionner reçus en série par l'intermédiaire de l'entrée de données série (DI) de la mémoire.

9. Décodeur selon la revendication 8, caractérisé en ce que les moyens de commutation d'une bascule comprennent un inverseur dont l'entrée est reliée à un noeud d'entrée (H) de la bascule et dont la sortie est reliée à une sortie (S) de la bascule, pour imposer ledit potentiel non nul ou ledit potentiel nul sur la sortie (S) de la bascule lorsque le potentiel sur ledit noeud d'entrée (H) de la bascule est respectivement nul ou non nul.

10. Décodeur selon la revendication 9, caractérisé en ce que les moyens d'activation de la bascule comprennent un moyen formant interrupteur commandé pour imposer un potentiel nul sur ledit noeud d'entrée (H) de la bascule.

11. Décodeur selon l'une des revendications 9 ou 10, caractérisé en ce que les moyens de désactivation d'une bascule comprennent des moyens de décodage (M0-M2,N1) qui permettent d'imposer un potentiel nul sur ledit noeud d'entrée (H) de la bascule et des moyens supplétifs pour imposer un potentiel non nul sur ledit noeud d'entrée (H) de la bascule qui agissent à défaut d'action des moyens de décodage.

12. Décodeur selon la revendication 11, caractérisé en ce que les moyens de décodage comprennent, en série entre le noeud d'entrée (H) de la bascule et la masse, p transistors MOS de type N (M0-M2) dont les grilles de commande sont reliées à des entrées (B0-B2) de sélection de la bascule pour recevoir au moins certains des signaux de sélection (Bit0, Bit1, Bit2, Bit0 barre, Bit1 barre, Bit2 barre) ainsi qu'un autre transistor MOS de type N (N1) dont la grille de commande est reliée à la sortie (S) de la bascule.

13. Décodeur selon l'une quelconque des revendications 8 à 12, caractérisé en ce que les moyens pour générer les signaux de sélection (Bit0, Bit1, Bit2, Bit0 barre, Bit1 barre, Bit2 barre) comprennent :
- p portes logiques de type NON ET (NEO-NE2) qui, ensemble, reçoivent, sur une première entrée, successivement les p bits du code de ligne reçu, et qui, chacune, reçoivent, sur une seconde entrée, l'un parmi p signaux de synchronisation présentant une impulsion en phase, respectivement, avec le p-ième bit du code de ligne reçu ;
- p autres portes logiques de type NON ET (NE3-NE5) qui, ensemble, reçoivent sur une première entrée, successivement l'inverse logique des p bits du code de ligne reçu, et qui, chacune, reçoivent sur une seconde entrée, l'un parmi p signaux de synchronisation présentant une impulsion en phase, respectivement, avec le p-ième bit du code de ligne reçu.

14. Décodeur selon l'une quelconque des revendications 8 à 13, caractérisé en ce que, l'ensemble des lignes d'accès étant un ensemble ordonné, il comprend des moyens pour activer la ligne d'accès qui, dans l'ordre des lignes d'accès, suit une ligne d'accès déterminée qui est sélectionnée, et des moyens pour désactiver ladite ligne d'accès déterminée, en sorte que c'est alors ladite ligne d'accès suivante qui est sélectionnée.

15. Décodeur selon la revendication 14, caractérisé en ce que lesdits moyens pour activer la ligne d'accès qui, dans l'ordre des lignes d'accès, suit une ligne d'accès déterminée qui est sélectionnée, sont des moyens, commandés par un signal de commande (INCR1), pour activer une ligne d'accès lorsque d'une part la ligne d'accès précédente est activée et d'autre part celle qui précède cette dernière n'est pas activée.

16. Décodeur selon la revendication 14 ou selon la revendication 15, caractérisé en ce que lesdits moyens pour désactiver ladite ligne d'accès déterminée comprennent des moyens, commandés par un second signal de commande (INCR2), pour désactiver une ligne d'accès lorsque la ligne d'accès suivante est activée.

17. Mémoire en circuit intégré, du type à accès série, notamment en technologie EEPROM, comportant une entrée de données série (DI) et un plan mémoire proprement dit (MM) qui comprend des cellules mémoire sous la forme d'une matrice et accessibles par un groupe de ligne de bits et un groupe de lignes de mots, caractérisée en ce qu'elle comprend un décodeur de lignes de bits (COLDEC) et/ou un décodeur de lignes de mots (ROWDEC) selon l'une quelconque des revendications 8 à 16.
